# EUROPÄISCHE PATENTANMELDUNG

(11) **EP 1 443 093 A1**
(43) Veröffentlichungstag der Anmeldung: **04.08.2004**
(21) Anmeldenummer: 03090022.9
(22) Anmeldetag: 29.01.2003
(51) Int. Cl.: C09K 11/06, H05B 33/14

(54) **Molekulare zur Emission von Photolumineszenzstrahlen befähigte, chemische Verbindungen mit elektronenverschiebbaren Strukturen und ihre Verwendung in Photolumineszenz-Löschungsanzeigeelementen**

(71) Anmelder: Samsung SDI Co., Ltd., Suwon-Si, Kyungki-do (KR)
(72) Erfinder: Redecker, Michael, Dr., 12305 Berlin (DE)
(74) Vertreter: Hengelhaupt, Jürgen D., Dipl.-Ing.

(57) **Zusammenfassung**

Die Erfindung betrifft molekulare, zur Emission von Photolumineszenzstrahlen befähigte, chemische Verbindungen, die leicht verschiebbare Elektronen aufweisen, wobei die Verbindungen so strukturiert sind, dass sie erst im angeregten Zustand Dipolcharakter aufweisen. Die erfindungsgemäßen Verbindungen umfassen chemische Strukturen, die Elektronendonor - Elektronenakzeptor - Strukturen darstellen, welche über ein konjugiertes Brückenelement miteinander verbunden sind. Sie sind für einen Einsatz in optischen Vorrichtungen geeignet. Gegenstand der Erfindung sind auch die Verbindungen umfassende Photolumineszenz-Löschungselemente (Anzeigeelemente).

## Beschreibung

Die Erfindung betrifft molekulare, zur Emission von Photolumineszenzstrahlen befähigte, chemische Verbindungen mit elektronenverschiebbaren Strukturen für optische Vorrichtungen sowie sie umfassende Photolumineszenz-Löschungselemente (Anzeigeelemente).

Chemische Verbindungen, welche die Eigenschaft besitzen, energiereiche Strahlung (UV-Strahlung, Röntgenstrahlung, Kathodenstrahlung etc.) zu absorbieren und diese in längerwellige, in der Regel sichtbare Strahlung umzusetzen, werden als Luminophore bezeichnet. Den Vorgang nennt man Lumineszenz. Lumineszenz-Prozesse lassen sich nach Art der Energiezufuhr einteilen. So wird z.B. bei der Photolumineszenz das Elektron durch optische Anregung (Bestrahlung) in den höheren Energiezustand gebracht; wird dagegen die Emission von Licht durch Anlegen eines elektrischen Felds hervorgerufen, nennt man das ElektroLumineszenz.

Photolumineszenz-Löschungselemente [Photolumineszenz-Quenching-Devices (PQDs)] sind als reemissive Anzeigetechnologie für Displays bekannt, die unter Aussenbedingungen, wie z.B. starkem Sonnenlicht, benutzt werden. Sie verwenden Fremdlicht zur Generation von Photolumineszenzlicht, das im Anzeigeelement mit Hilfe einer angelegten Spannung moduliert werden kann. Gleichzeitig ist bei den Anzeigeelementen ein selbstemissiver Betriebsmodus möglich, der unter Bedingungen mit wenig oder keinem Fremdlicht genutzt werden kann.

Das zugrundeliegende Prinzip ist bekannt. Es verläuft nach dem Mechanismus, dass die Aufspaltung des angeregten Zustandes unter Einwirkung eines elektrischen Feldes die Steuerung der Intensität des emittierten Lichts erlaubt. Diese Aufspaltung liefert Ladungsträger, die über die Kontakte abtransportiert werden. Der Arbeitsmechanismus verläuft damit entgegengesetzt dem einer organischen Leuchtdiode (OLED), in der Ladungsträger unter Lichtemission rekombinieren.

Als Materialien in PQDs werden gegenwärtig insbesondere konjugierte Polymere aus den Materialklassen mit der Grundstruktur von Poly(phenylenvinylen) (PPV) und Polyfluoren (PFO) genutzt. Diese Materialien sind allerdings für die Anwendung in polymeren organischen Leuchtdioden (PLEDS) entwickelt worden und zeigen bei der Anwendung in PQD-Elementen erst bei einem recht hohen elektrischen Feld von 2.5x10⁸ V/m eine Fluoreszenzlöschung größer 70 %.

Das Ziel der Erfindung bestand nun darin, Materialien zu finden, die eine Verstärkung der Kopplung zwischen elektrischem Feld und angeregtem Zustand gestatten. Dafür sind Donor-Akzeptor-Strukturen an sich bekannt. Sie finden insbesondere in Materialien mit stark nichtlinear-optischen Eigenschaften Verwendung.

Entsprechende chemische Verbindungen sind unter anderem in US 6,288,206 Bl (chirale Materialien für nichtlinear-optische Anwendungen) und in US 5,745,629 A (Polymere für nichtlinear-optische Anwendungen) beschrieben. Jedoch ist die Emission von Photolumineszenzstrahlung in diesen Fällen zweitrangig, da die Feldabhängigkeit der Absorption und insbesondere die des Brechungsindexes vorrangig genutzt werden sollen. Diese eingesetzten Verbindungen zeigen sehr starke Donor-Akzeptor-Wechselwirkungen bereits im Grundzustand des Materials, was den Nachteil hat, dass diese Materialien aufgrund der starken Polarität in der Regel nicht emissiv sind, wodurch sie für eine Anwendung in PQD-Anzeigeelementen ungeeignet sind.

Der Erfindung lag deshalb die Aufgabe zugrunde, chemische Materialien zu finden, die einerseits eine hohe Fluoreszenzlöschung gewährleisten, andererseits das für die Löschung der Photolumineszenz benötigte elektrische Feld herabsetzen sowie emissive Eigenschaften aufweisen, welche die Modulation von ausgesandtem Photolumineszenzlicht mittels eines elektrischen Feldes in einem Photolumineszenz-Löschungselement (PQD) erlauben und die darüber hinaus eine hohe Photolumineszenz-Quantenausbeute besitzen.

Die Aufgabe wird durch Bereitstellung molekularer chemischer Strukturen (Schichten) gelöst, die ein System mit leicht verschiebbaren Elektronen besitzen, welche dann im angeregten Zustand zu dem gewünschten Dipol führen.

Die Aufgabe wird erfindungsgemäß durch Verbindungen (chemische Materialien) gelöst, die Donor-Akzeptor-Strukturen darstellen, wobei Donor- und Akzeptorteil durch chemische Strukturen miteinander verbunden sind, die als konjugierte Brücke wirken.

Der elektronenreiche Donorteil ist über dieses konjugierte Brückenelement mit dem elektronenarmen Akzeptorteil verbunden. Dabei sind die erfindungsgemäßen Verbindungen so konstruiert, dass ihr Donor- und Akzeptorcharakter im Grundzustand noch kein nennenswertes Dipolmoment ausbildet, sondern dieses sich erst im angeregten Zustand entwickelt.

Es hat sich gezeigt, dass diese chemischen Verbindungen aufgrund ihrer erfindungemäßen Struktur (als chemisches Donor- konjugiertes Brückenelement - Akzeptor - Material) besonders gut für die Anwendung in PQD-Anzeigeelementen geeignet sind. Die stärkere Kopplung wird durch eine stärkere räumliche Ausdehnung sowie einen stärker dipolaren Charakter des angeregten Zustands erreicht. Im angeregten Zustand kann das von außen angelegte elektrische Feld dann am Dipol angreifen und zur Ladungsseparation führen.

Die Erfindung wird gemäß den Ansprüchen 1, 14, und 15 realisiert. Die Unteransprüche stellen Vorzugsvarianten dar.

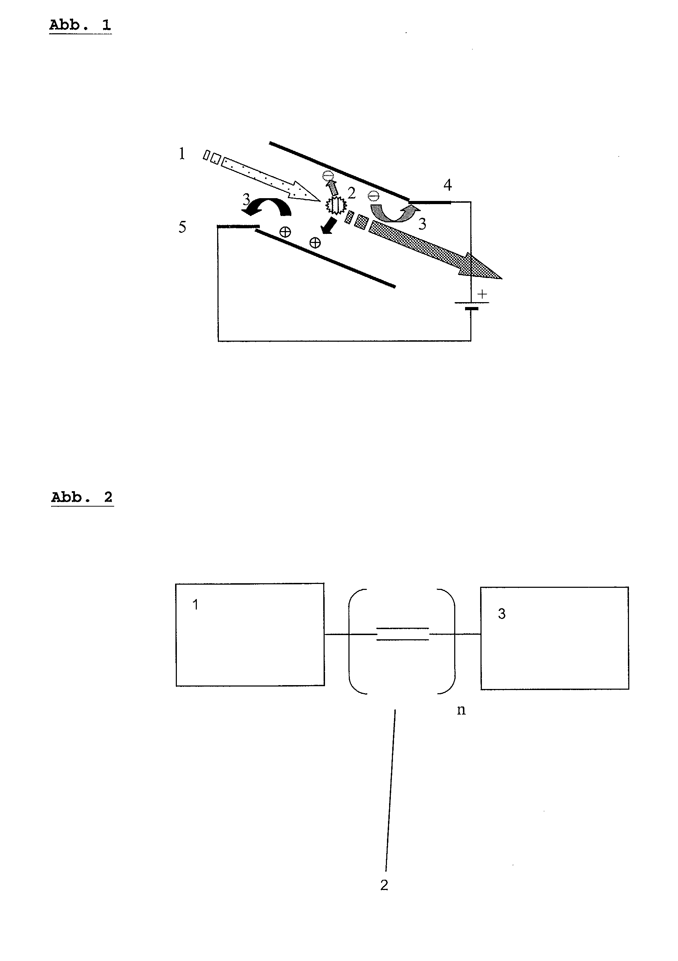

Das zugrunde liegende Prinzip eines PQDs ist in Abb. 1 erläutert. In Analogie zum OLED Display ist der Aufbau eines PQD Display im Prinzip ebenfalls sehr einfach. Zwischen zwei Metallisierungen ist die (hauchdünne) molekulare chemische Schicht eingebettet. Durch Absorption von Umgebungslicht werden angeregte Zustände im Material erzeugt. Diese können unter Lichtemission strahlend zerfallen. Durch Anlegen einer Spannung an die beiden Kontakte wird ein elektrisches Feld aufgebaut. Durch das elektrische Feld werden die angeregten Zustände zu Ladungsträgern getrennt und diese über die Kontakte abtransportiert.

Zur Vermeidung von Korrrosion und chemischer Degradation wird die gesamte Struktur in Inertgasathmosphäre aufgebaut und gasdicht verkapselt. Je besser die Versiegelung ausfällt, desto höher ist die zu erwartende Lebensdauer des Displays.

Das strukturelle Aufbauprinzip der erfindungsgemäßen molekularen chemischen Donor-konjugiertes Brückenelement-Akzeptor-Schicht ist in Abb. 2 dargestellt.

Die Herstellung der erfindungsgemäßen Verbindungen erfolgt nach dem Fachmann bekannten Verfahren, so können z.B. die einzelnen Strukturelemente nach beschriebenem (bekanntem) Baukastensystem zusammengefügt werden. Dabei sind sowohl die Kreation von Oligomeren bzw. Monomeren als auch die Herstellung polymerer Strukturen möglich. Dünne Monomer- und Oligomerschichten können durch Aufdampfen im Hochvakuum hergestellt werden. Dabei werden die entsprechenden Materialien im Hochvakuum aus einer heizbaren Verdampfungsquelle verdampft und schlagen sich als kompakter dünner Film auf den ebenfalls im Hochvakuum befindlichen Substraten nieder. Typische Basisdrücke liegen im Bereich von 10⁻⁴ bis 10⁻⁹ mbar.

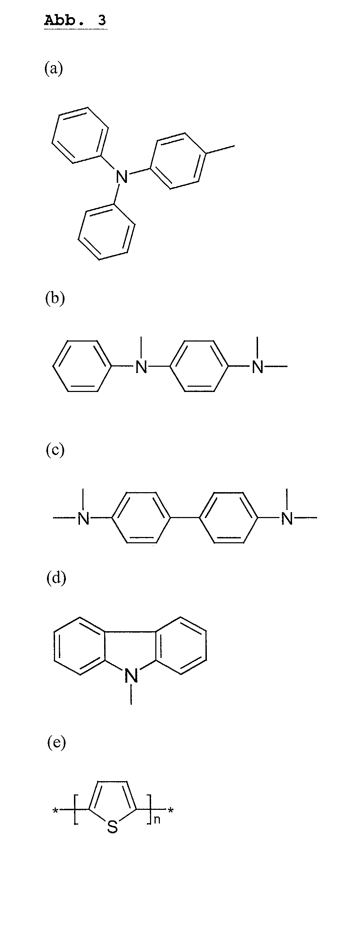

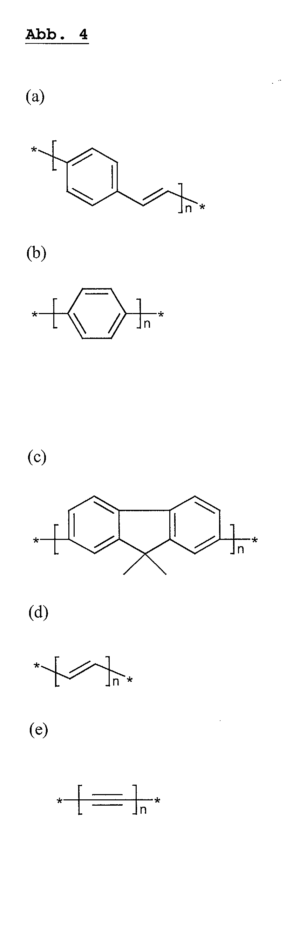

Gemäß der Erfindung sind chemische Grundstrukturen für ein solches Elektronendonor-Strukturelement bevorzugt aromatische Amine und kondensierte cyclische Systeme. Insbesondere sind es die aromatischen Amine (a) Triphenylamin, (b) Phenylendiamin bzw. p-Semidin (Aminodiphenylamin) und (c) Benzidin sowie die kondensierten cyclischen Systeme (d) Carbazol (Dibenzopyrrol) und (e) Thiophen und Oligomere. Besonders bevorzugt geeignete Strukturklassen für diesen Donorteil stellen die Verbindungen der Abb. 3 dar (Verbindungen 3(a) bis 3(e)).

Konjugierte Brückenelemente gemäß vorliegender Erfindung sind bevorzugt ausgewählt aus der Stoffgruppe der pi-konjugierten organischen Verbindungen. Insbesondere sind die Verbindungen ausgewählt aus
(a) Phenylenvinylen-Einheiten in Form von Oligomeren und Polymeren sowie deren Substitutionsprodukten
(b) Phenylen-Einheiten in Form von Oligomeren und Polymeren sowie deren Substitutionsprodukten
(c) Fluoren-Einheiten in Form von Oligomeren und Polymeren sowie deren Substitutionsprodukten
(d) Vinylen-Einheiten in Form von Oligomeren und Polymeren sowie deren Substitutionsprodukten
(e) Ethinylen-Einheiten in Form von Oligomeren und Polymeren sowie deren Substitutionsprodukten
(f) Anthranylen-Einheiten in Form von Oligomeren und Polymeren sowie deren Substitutionsprodukten
(g) Napthylen-Einheiten in Form von Oligomeren und Polymeren sowie deren Substitutionsprodukten.

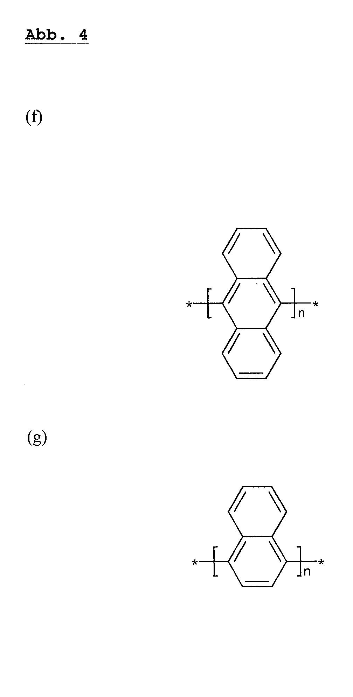

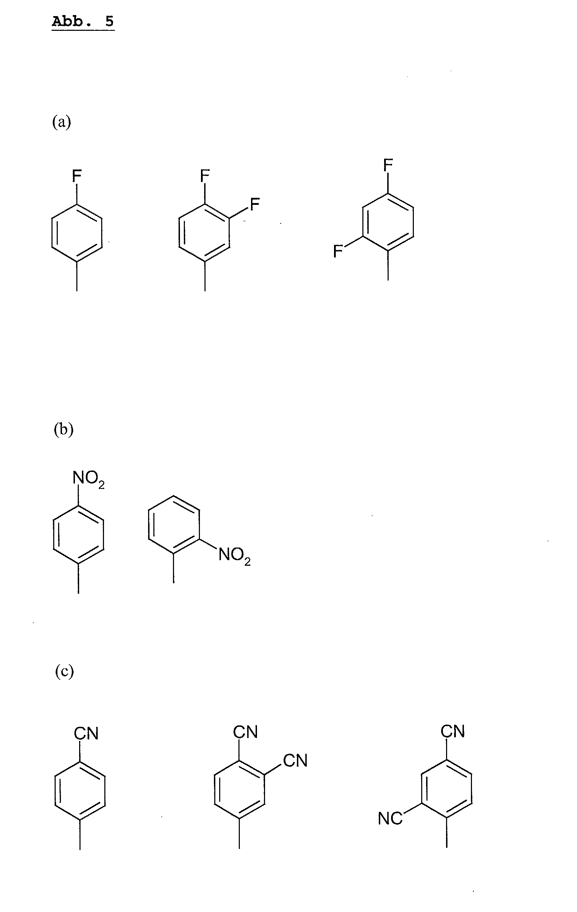

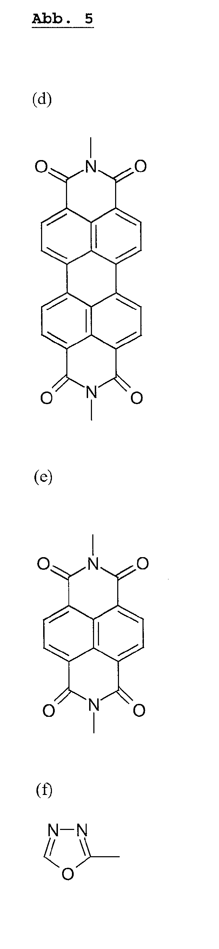

Besonders bevorzugt geeignete Strukturklassen für ein konjugiertes Brückenelement sind die Verbindungen der Abb. 4 (Verbindungen 4 (a) bis 4 (g) , wobei n = 1 bis 20 bedeuten kann).

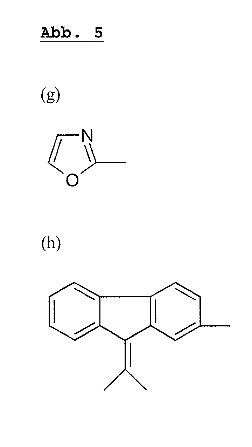

Bevorzugte chemische Grundstrukturen für Elektronenakzeptor-Verbindungen sind mono-, di- und/oder trisubstituierte Phenyle, Imide und Anhydride aromatischer Polycarbonsäuren und Oxazole sowie kondensierte aromatische Ringsysteme. Vorzugsweise sind es
(a) Fluor-substituierte Phenylgruppen (mono, di- und/oder trisubstituert)
(b) Nitro-substituierte Phenylgruppen, vorzugsweise m- und p-substituiert,
(c) Cyano-substituierte Phenylgruppen, vorzugsweise monooder disubstituiert,
(d) Imide and Anhydride von Perylentetrakarbonsäure sowie deren Substitutionsprodukte
(e) Imide and Anhydride von Naphthalintetrakarbonsäure sowie deren Substitutionsprodukte
(f) Oxadiazole sowie deren Substitutionsprodukte
(g) Oxazole sowie deren Substitutionsprodukte
(h)Fluorenilyden-Einheiten sowie deren Substitutionsprodukte
Besonders bevorzugt sind es Verbindugnen der in Abb. 5 dargestellten Akzeptor-Strukturelemente (Verbindungen 5(a) bis 5(h)).

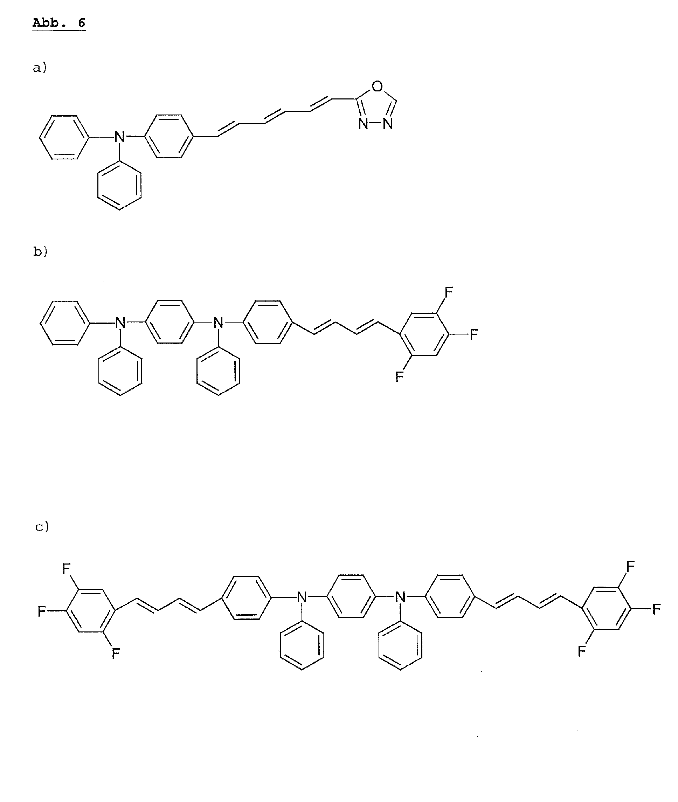

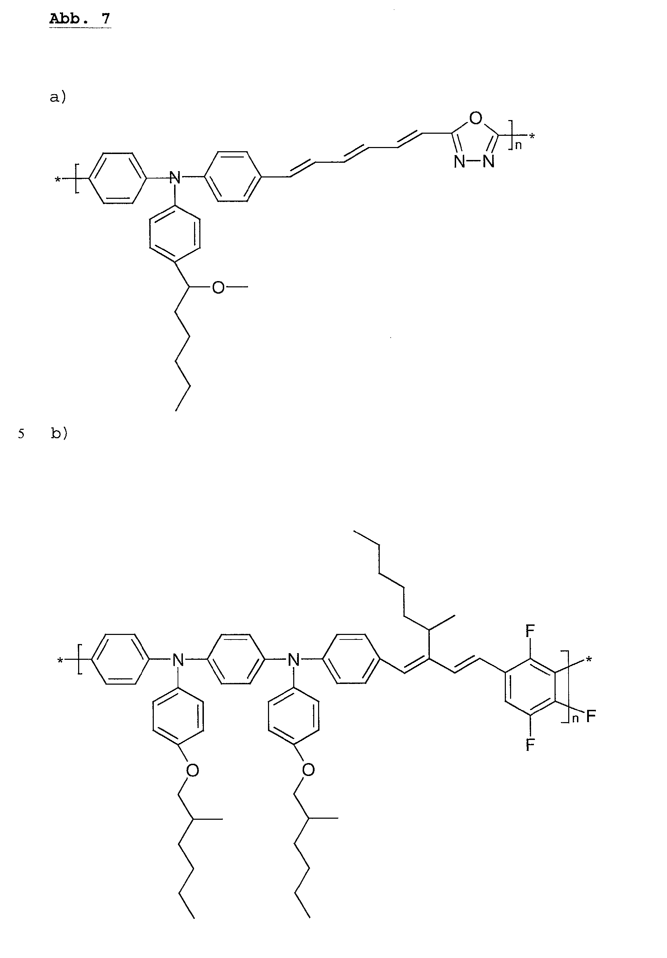

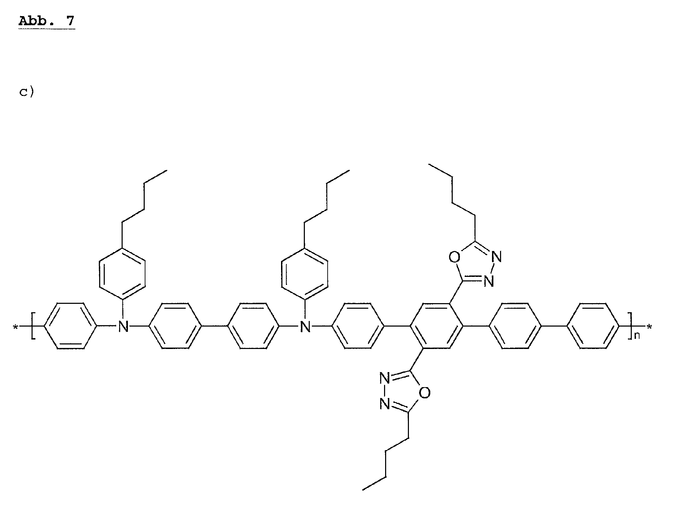

Ganz besonders bevorzugte erfindungsgemäße, molekulare, zur Emission von Photolumineszenzstrahlen befähigte, chemische Verbindungen mit elektronenverschiebbaren Strukturen sind Donor-Brücken-Akzeptor Strukturen in Form von Oligomeren und Monomeren der Abb. 6 (Verbindungen 6(a) bis 6(c) sowie Verbindungen der Abb. 7, welche Pendants auf Polymerbasis darstellen (Verbindungen 7(a) bis 7(c), n = 100 bis 2000).

In einer weiteren Ausführungsvariante der Erfindung weisen die erfindungsgemäßen Brückenstrukturen zur Verbesserung der Löslichkeit bevorzugt noch zusätzlich eingebrachte Seitenketten und Substitutionen auf. Bevorzugt werden verzweigte Alkyl- und Alkoxygruppen verwendet, mit einer bevorzugten Anzahl von vier bis vierzehn Kohlenstoffatomen. Die Verknüpfung von Donor - und Akzeptorteil kann sowohl in der Hauptkette des Brückenelementes erfolgen wie auch in die Seitengruppen hineinreichen.

Die erfindungsgemäß bereitgestellten Verbindungen sind hervorragend zum Einsatz in Photolumineszenz-Löschungselementen geeignet. Sie weisen emissive Eigenschaften auf, gewährleisten eine hohe Fluoreszenzlöschung, wobei das für die Löschung der Hälfte der ohne Feld emittierten Photolumineszenzstrahlung benötigte elektrische Feld kleiner als 1.5*10⁸ V/m ist, und besitzen darüber hinaus eine hohe Photolumineszenz-Quantenausbeute. Typische Fluoreszenz-Quantenausbeuten liegen bei Werten grösser 40 Prozent. Als besonders geeignet haben sich die erfindungsgemäßen Materialien mit der Struktur der Abb. 7(a), (b) und (c) erwiesen.

Ein gemäß der Erfindung bevorzugtes Photolumineszenz-Löschungselement (PQD) unter Verwendung eines polymeren Emittermaterials, das als dünner Film in das PQD-Anzeigeelement integriert wird, ist wie folgt aufgebaut:

Basierend auf einem durchsichtigen Substrat, vorzugsweise auf einem Glassubstrat, das mit leitfähigem transparentem Indium-Zinnoxyd (ITO) beschichtet ist, wird das Anzeigeelement aufgebaut.

Auf die ITO-Schicht wird eine Schicht des leitfähigen Polymers Poly(ethylendioxythiophen)/Polystyrolsulfonsäure aufgeschleudert. Diese Schicht dient insbesondere zur Glättung eventueller Oberflächenrauhigkeiten. Die bevorzugte typische Schichtdicke liegt im Bereich von 30-100 Nanometern.

Die erfindungsgemäßen Polymere werden durch Aufschleudern aus einem geeigneten organischen Lösungsmittel wie Toluol, Xylol, Chloroform oder Chlorbenzol zu dünnen Filmen verarbeitet. Nachfolgend wird eine Schicht von Emitterpolymer gemäß Abb. 7(a), (b) oder (c) mit einer typischen Dicke von 50-150 Nanometern aufgeschleudert.

Die Struktur wird vervollständigt durch Abscheiden eines Metallkontaktes im Hochvakuum. Die Metalle sind ausgewählt aus Aluminium, Calcium, Ytterbium, Silber, Titan, Magnesium, Zink und Indium. Ebenso können Kombinationen dieser Metalle mit dünnen Isolatorschichten aus Fluoriden und Oxiden der Alkali- und Erdalkalimetalle verwendet werden.

Bevorzugt kommt hier Lithiumfluorid mit einer Dicke von einem Nanometer zum Einsatz, das durch thermisches Aufdampfen im Hochvakuum abgeschieden wird. Auf diese Schicht wird vorzugsweise eine Aluminiumschicht mit einer typischen Dicke von 50-200 Nanometern aufgedampft. Die Struktur wird vervollständigt durch eine Verkapselung bevorzugt aus Glas, die durch einen Kleber gasdicht versiegelt wird.

Die Struktur emittiert unter Bestrahlung mit Sonnenlicht Photolumineszenzstrahlung. Durch Anlegen einer Spannung zwischen Metallkontakt und ITO-Kontakt kann die Intensität der Photolumineszenz abgeschwächt werden. Dabei ist der Metallkontakt positiv gegen den ITO-Kontakt gepolt. Bei einer angelegten Spannung von 15 Volt wird mehr als die Hälfte der emittierten Photolumineszenzstrahlung unterdrückt.

Weiterhin ist die Erfindung beispielhaft in den Abbildungen 1 bis 7 dargestellt, auf die sie jedoch nicht beschränkt werden soll.

### Abb. 1

Funktionsprinzip von PQD-Anzeigeelementen
1. Absorbtion von Umgebungslicht
2. Strahlender Zerfall des angeregten Zustands bzw. Dissoziation zu Ladungsträgern
3. Extraktion der Ladungsträger durch die Kontakte
4. Kontakt mit niedriger Elektronen-Austrittsarbeit
5. Kontakt mit hoher Elektronen-Austrittsarbeit

### Abb. 2

Prinzipieller Aufbau der Donor-Akzeptor-Struktur
1. Donor-Strukturelement
2. Konjugiertes Brückenelement
3. Akzeptor-Strukturelement

### Abb. 3

Chemische Grundstrukturen für das Donor-Strukturelement
(a) Triphenylamin
(b) Phenylendiamin
(c) Benzidin
(d) Carbazol
(e) Thiophen und Oligomere

### Abb. 4

Chemische Grundstrukturen für das konjugierte Brückenelement
(a) Phenylenvinylen-Einheiten in Oligomeren sowie Polymeren sowie deren Substitutionsprodukte
(b) Phenylen-Einheiten in Oligomeren und Polymeren sowie deren Substitutionsprodukte
(c) Fluoren-Einheiten in Oligomeren und Polymeren sowie deren Substitutionsprodukte
(d) Vinylen-Einheiten in Oligomeren und Polymeren sowie deren Substitutionsprodukte
(e) Ethinylen-Einheiten in Oligomeren und Polymeren sowie deren Substitutionsprodukte
(f) Anthranyl-Einheiten in Oligomeren und Polymeren sowie deren Substitutionsprodukte
(g) Napthylen-Einheiten in Oligomeren und Polymeren sowie deren Substitutionsprodukte

### Abb. 5

Chemische Grundstrukturen für das Akzeptor-Strukturelement
(a) Fluor-substituierte Phenylgruppen
(b) Nitro- substituierte Phenylgruppen
(c) Cyano- substituierte Phenylgruppen
(d) Imide and Anhydride von Perylentetrakarbonsäure sowie deren Substitutionsprodukte
(e) Imide and Anhydride von Naphthalintetrakarbonsäure sowie deren Substitutionsprodukte
(f) Oxadiazole sowie deren Substitutionsprodukte
(g) Oxazole sowie deren Substitutionsprodukte
(h) Fluorenilyden-Einheiten sowie deren Substitutionsprodukte

### Abb. 6

Typische Strukturen für Donor-Akzeptor-Materialien auf der Basis kleiner Moleküle
(a)Triphenylamin-Oxadiazol-Kombination, unsymmetrisch
(b) Phenylendiamin-Trifluorbenzol-Kombination,unsymmetrisch
(c) Phenylendiamin-di-Trifluorbenzol-Kombination,symmetrisch

### Abb. 7

Typische Strukturen für Donor-Akzeptor-Materialien auf der Basis von Polymeren
(a) Triphenylamin-Oxadiazol-Kombination, Donor und Akzeptor in der Hauptkette
(b) Phenylendiamin-Trifluorbenzol-Kombination, Donor und Akzeptor in der Hauptkette
(c) Benzidin-di-Oxadiazol-Kombination, Donor in der Hauptkette, Akzeptor als Seitengruppe

## Patentansprüche

1. Molekulare, zur Emission von Photolumineszenzstrahlen befähigte, chemische Verbindungen, die leicht verschiebbare Elektronen aufweisen, wobei die Verbindungen so strukturiert sind, dass sie erst im angeregten Zustand Dipolcharakter aufweisen, umfassend chemische Strukturen, die Elektronendonor - Elektronenakzeptor - Strukturen darstellen, welche über ein konjugiertes Brückenelement miteinander verbunden sind.

2. Verbindungen nach Anspruch 1, **dadurch gekennzeichnet, dass** das Donorstrukturelement ein aromatisches Amin oder ein kondensiertes cyclisches System darstellt.

3. Verbindungen nach Anspruch 2, **dadurch gekennzeichnet, dass** das aromatische Amin Triphenylamin, Phenylendiamin oder Benzidin ist.

4. Verbindungen nach Anspruch 2, **dadurch gekennzeichnet, dass** das kondensierte cyclische System Carbazol oder Thiophen und dessen Oligomere ist.

5. Verbindungen nach einem der Ansprüche 3 oder 4, **dadurch gekennzeichnet, dass** das Donorstrukturelement ausgewählt ist aus den folgenden Verbindungen 3(a) bis 3 (e)

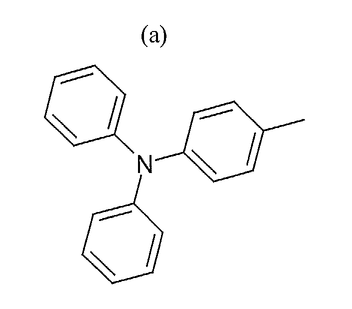

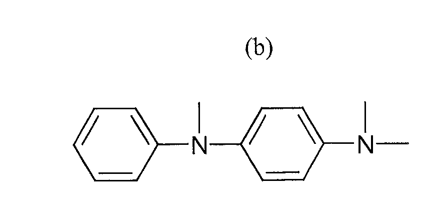

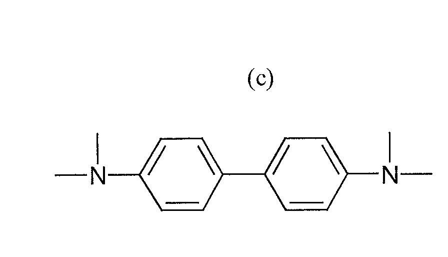

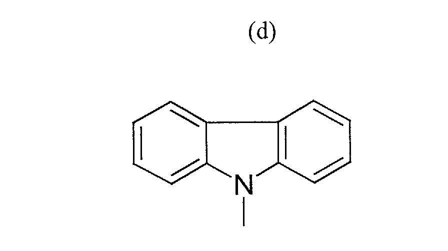

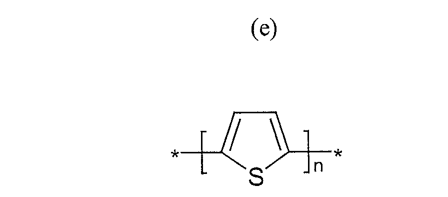

6. Verbindungen nach Anspruch 1, **dadurch gekennzeichnet, dass** das konjugierte Brückenelement aus pi-konjugierten Kohlenstoffbindungen besteht.

7. Verbindungen nach Anspruch 6, **dadurch gekennzeichnet, dass** die pi-konjugierte Kohlenstoffbindung ein organisches Polymer mit einer chemischen Grundstruktur aus Phenylenvinylen-Einheiten in Form von Oligomeren und Polymeren sowie deren Substitutionsprodukten, aus Phenylen-Einheiten in Form von Oligomeren und Polymeren sowie deren Substitutionsprodukten, aus Fluoren-Einheiten in Form von Oligomeren und Polymeren sowie deren Substitutionsprodukten, aus Vinylen-Einheiten in Form von Oligomeren und Polymeren sowie deren Substitutionsprodukten, aus Ethinylen-Einheiten in Form von Oligomeren und Polymeren sowie deren Substitutionsprodukten, aus Anthranylen-Einheiten in Form von Oligomeren und Polymeren sowie deren Substitutionsprodukten oder aus Napthylen-Einheiten in Form von Oligomeren und Polymeren sowie deren Substitutionsprodukten darstellt.

8. Verbindungen nach Anspruch 7, **dadurch gekennzeichnet, dass** das konjugierte Brückenelement ausgewählt ist aus den folgenden Verbindungen 4(a) bis 4(g)

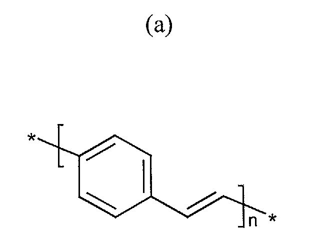

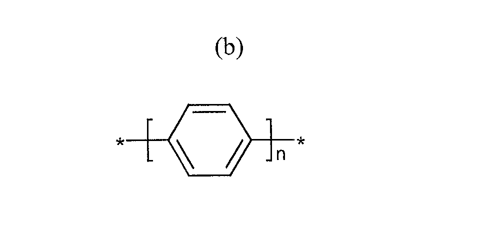

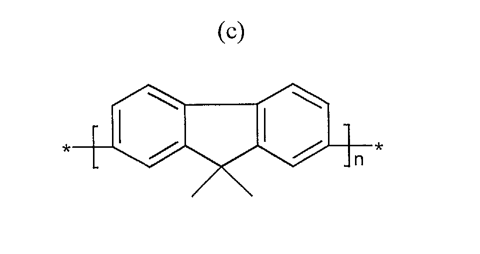

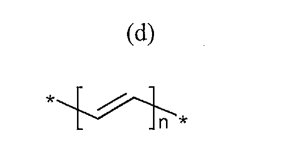

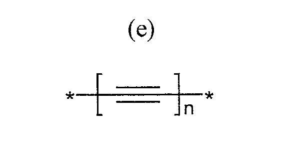

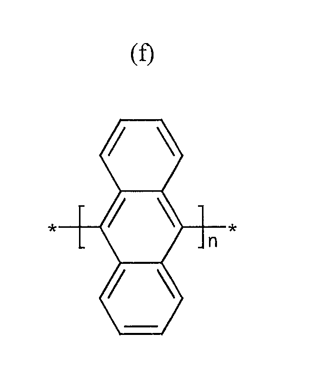

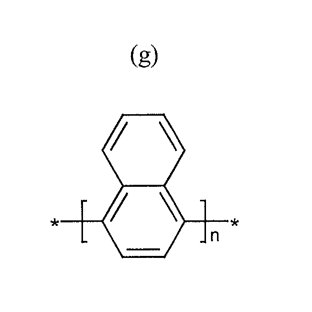

9. Verbindungen nach Anspruch 1, **dadurch gekennzeichnet, dass** das Akzeptorstrukturelement ausgewählt aus mono-, di- oder trisubstituierten Phenylen, Imiden und Anhydriden aromatischer Polycarbonsäuren und Oxazole sowie kondensierter aromatischer Ringsysteme ist.

10. Verbindungen nach Anspruch 9, **dadurch gekennzeichnet, dass** das Akzeptorstrukturelement eine chemische Grundstruktur aus Fluor-substituierten Phenylgruppen, aus Nitro-substituierten Phenylgruppen, aus Cyanosubstituierten Phenylgruppen, aus Imiden und Anhydriden von Perylentetrakarbonsäure sowie deren Substitutionsprodukten, aus Imiden und Anhydriden von Naphthalintetrakarbonsäure sowie deren Substitutionsprodukten, aus Oxadiazolen sowie deren Substitutionsprodukten, aus Oxazolen sowie deren Substitutionsprodukten oder aus Fluorenilyden-Einheiten sowie deren Substitutionsprodukten darstellt.

11. Verbindungen nach Anspruch 10, **dadurch gekennzeichnet, dass** das Akzeptorstrukturelement ausgewählt ist aus den folgenden Verbindungen 5(a) bis 5(h)

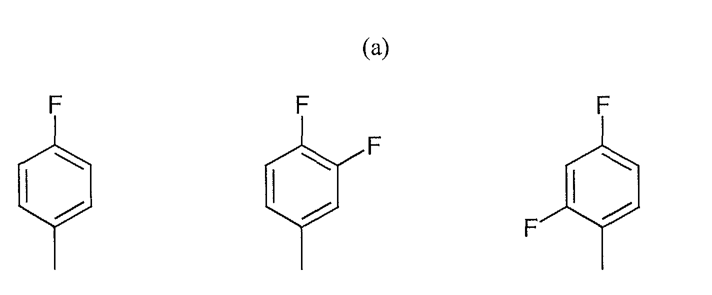

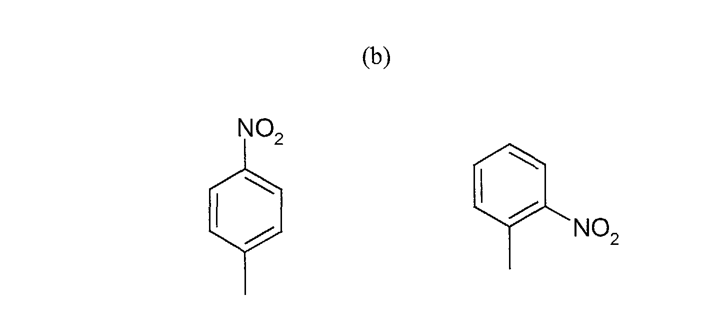

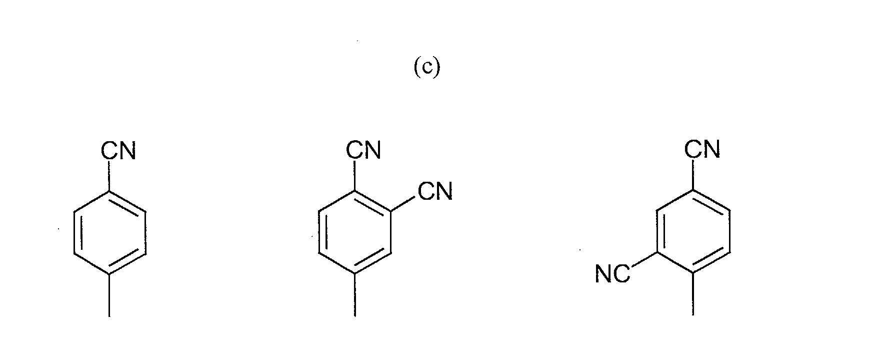

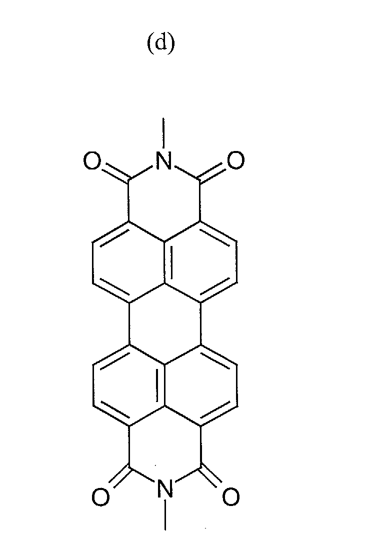

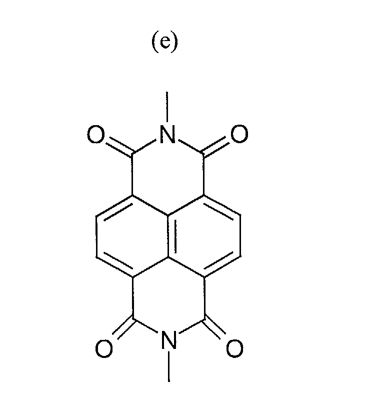

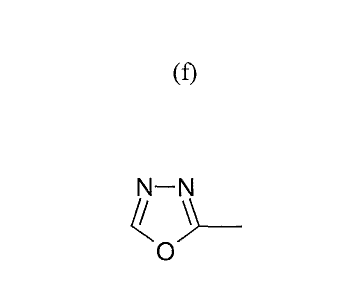

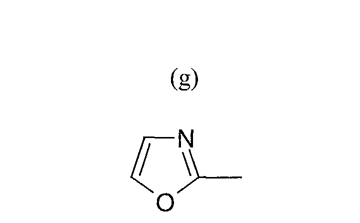

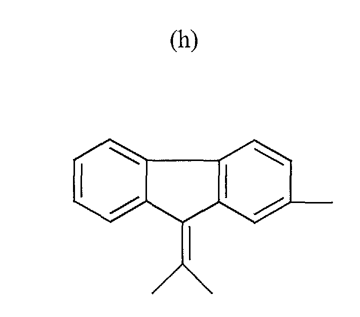

12. Verbindungen nach einem der Ansprüche 1 bis 11, **dadurch gekennzeichnet, dass** die Elektronendonor - Brückenglied - Elektronenakzeptor - Strukturen Verbindungen sind ausgewählt aus den folgenden Verbindungen 6(a) bis 6(c)

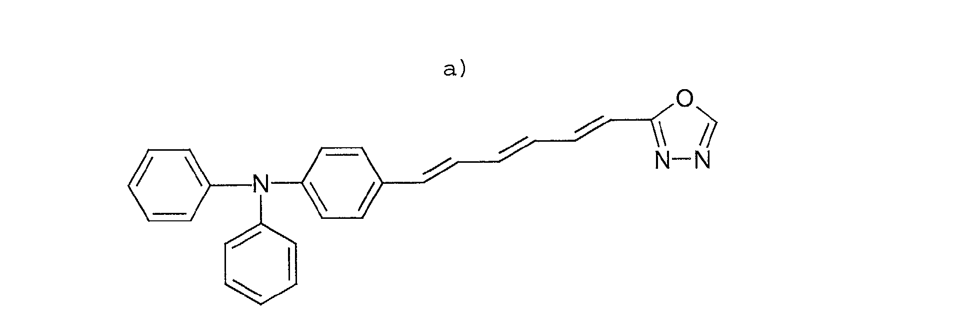

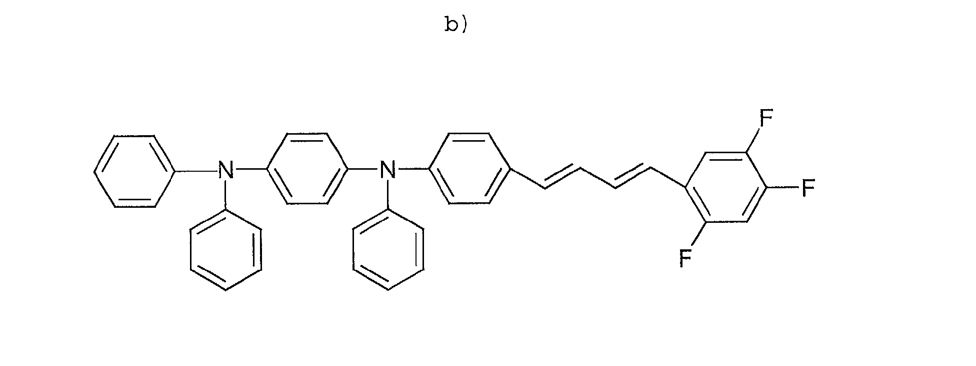

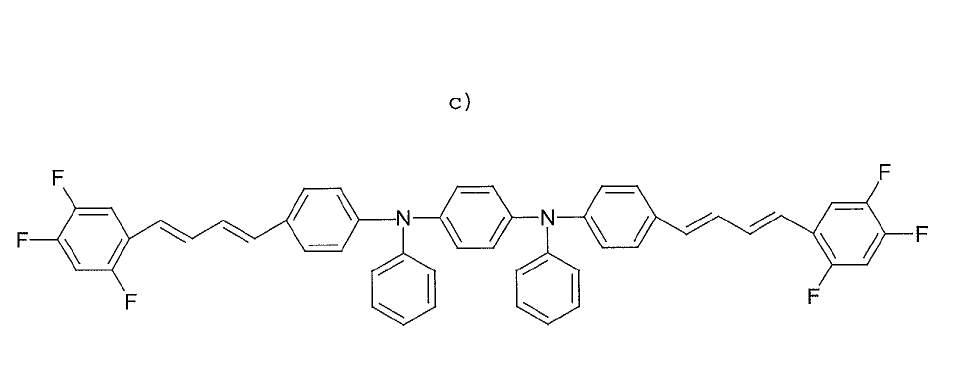

13. Verbindungen nach einem der Ansprüche 1 bis 11, **dadurch gekennzeichnet, dass** die Elektronendonor - Brückenglied - Elektronenakzeptor - Strukturen Verbindungen sind ausgewählt aus den folgenden Verbindungen 7(a) bis 7(c)

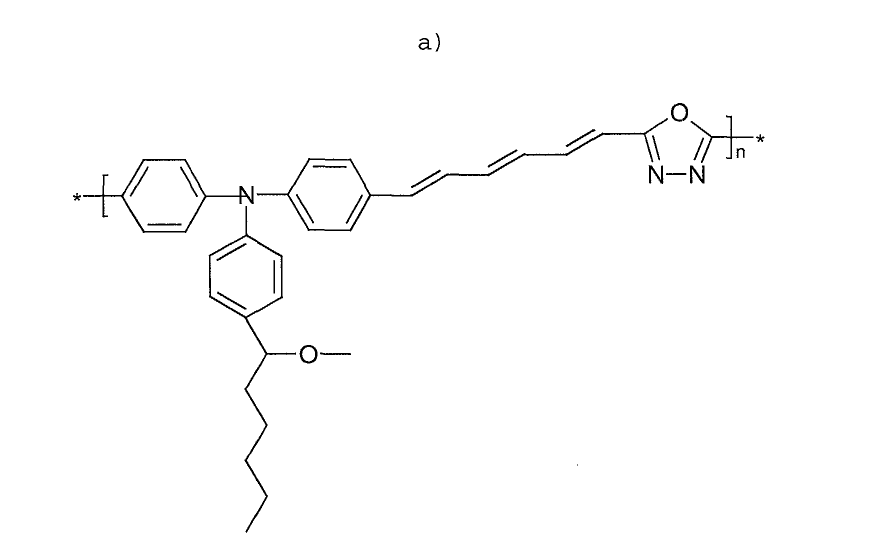

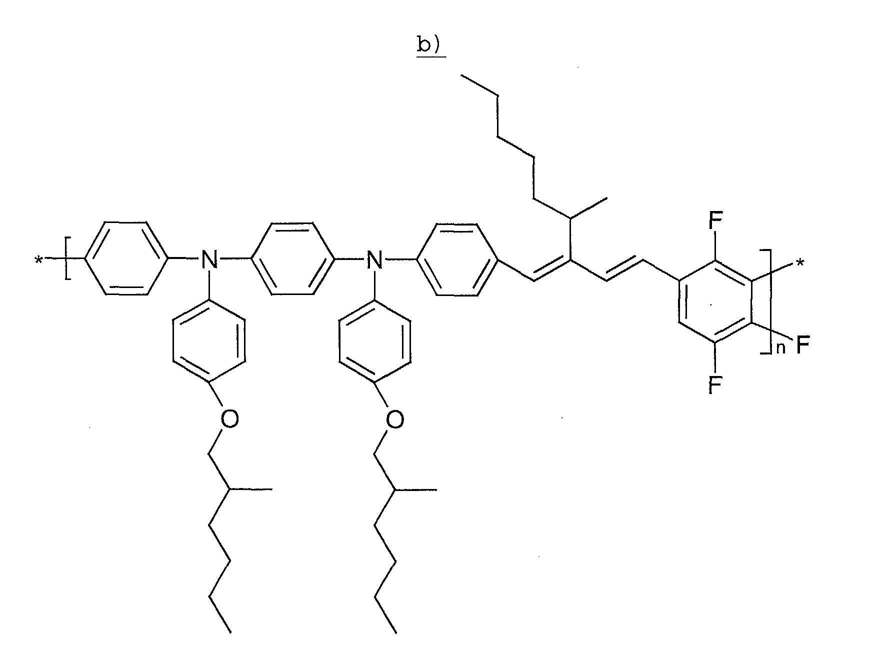

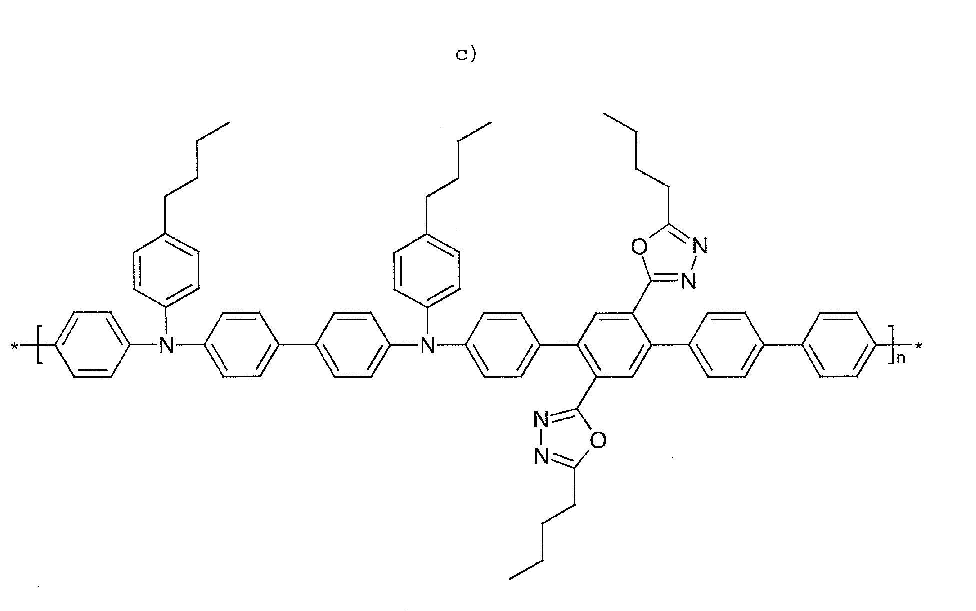

14. Verwendung der Verbindungen nach einem der Ansprüche 1 bis 13 für optische Vorrichtungen in Photolumineszenz-Löschungselementen.

15. Photolumineszenz-Löschungselemente umfassend eine chemische Verbindung gemäß einem der Ansprüche 1 bis 13.

16. Photolumineszenz-Löschungselement nach Anspruch 15, **gekennzeichnet durch**
- ein Glassubstrat,
- einer Schicht aus leitfähigem transparentem Indium-Zinnoxyd (ITO),
- einer Schicht des leitfähigen Polymers Poly(ethylendioxythiophen)/Polystyrolsulfonsäure mit einer Schichtdicke von 30 bis 100 nm,
- einer Schicht Emitterpolymer ausgewählt aus den Verbindungen 7(a) bis 7(c) 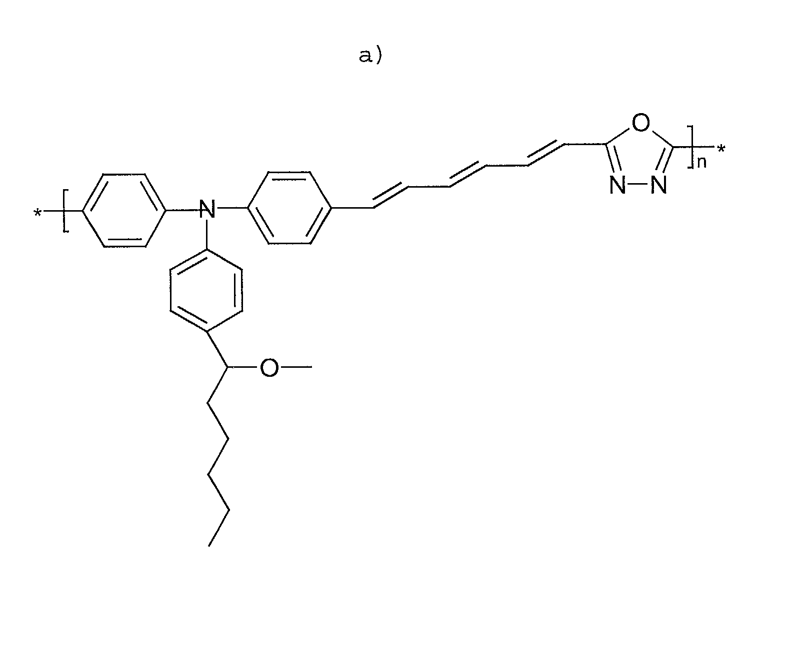 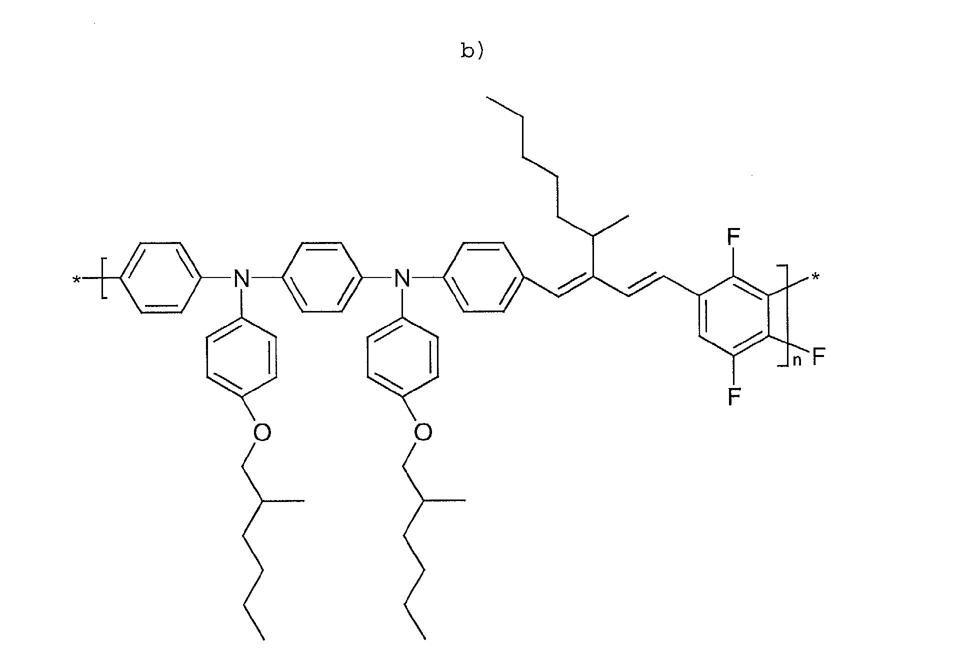 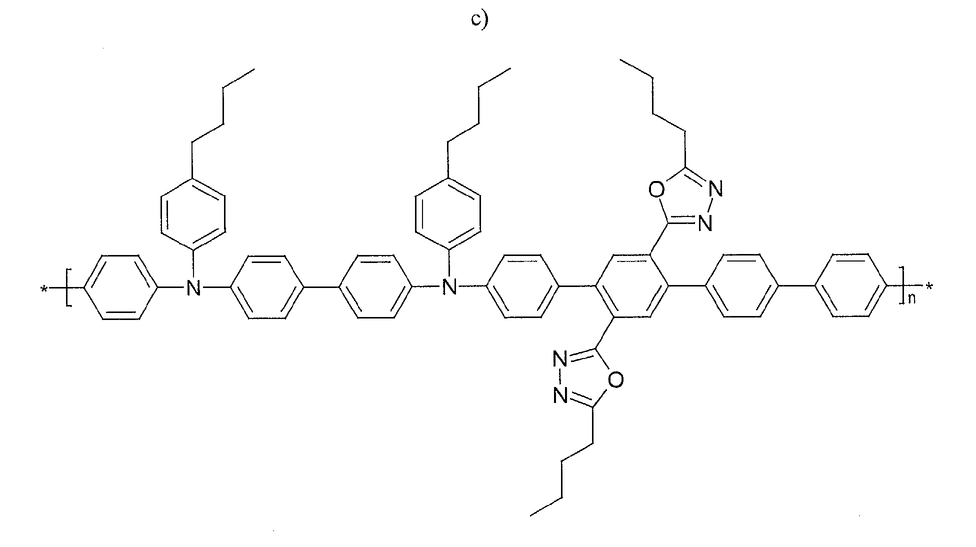 mit einer Schichtdicke von 50 bis 150 nm,
- einem Metallkontakt, ggf, in Kombination mit einer dünnen Isolatorschicht und
- einer Aluminiumschicht mit einer Schichtdicke von 50 bis 200 nm.
